# FASCICULE DE BREVET EUROPEEN

(11) **EP 0 346 224 B1**
(45) Date de publication et mention de la délivrance du brevet: **17.03.1993**
(21) Numéro de dépôt: 89401574.2
(22) Date de dépôt: 07.06.1989
(51) Int. Cl.: H01L 21/00

(54) **Couloir adaptable pour le transport de pièces dans un environnement ultra-propre**
Rinne zum Transport von Teilen in einem ultrareinen Raum
Adaptable channel for the transport of work pieces in an ultra-clean environment

(30) Priorité: 09.06.1988 FR 8807682
(43) Date de publication de la demande: 13.12.1989
(73) Titulaire: COMMISSARIAT A L'ENERGIE ATOMIQUE, 75015 Paris Cédex 15 (FR)
(72) Inventeur: Lazzari, Jean-Pierre, F-38700 Corenc (FR)
(74) Mandataire: Mongrédien, André

(56) Documents cités:
- US-A- 4 540 326

## Description

La présente invention a pour objet un couloir adaptable pour le transport de pièces dans un environnement ultra-propre. Elle s'applique notamment à la protection contre la pollution de tranches de silicium pendant leur transport.

Lors de la fabrication des circuits intégrés, les tranches de silicium sont stockées dans des stations de chargement et de déchargement. On les achemine par des moyens de transport adaptés (coussins d'air, courroies...) vers des stations de traitement (réacteur, insolateur, four...), puis on les stocke à nouveau après traitement.

Les différentes stations de traitement sont soumises à un environnement ultra-propre et non polluant pour les tranches, mais une contamination par poussière est toujours possible lors du transport, si celui-ci ne bénéficie pas de précautions d'environnement particulières.

Pour résoudre le problème de la pollution lors de l'acheminement des tranches vers les stations, on place habituellement les moyens de transport dans un tube rigide adapté et soumis à une circulation d'air non polluant. Cette solution présente l'inconvénient majeur de nécessiter une mécanique adaptée une fois pour toutes à l'équipement et difficilement applicable à tous les cas de transports rencontrés lors des cheminements des tranches.

On connaît également d'après le brevet US 4,540,326, un couloir pour le transport de pastilles de semiconducteur. Ce couloir est constitué d'une part, d'une piste sur laquelle peut circuler un chariot portant la boîte support de pastilles et d'autre part, d'un tunnel en U recouvrant ladite piste. Le tunnel est formé par plusieurs pièces en U assemblées bout à bout. Il est nécessaire de purger ce tunnel par de l'azote ou de l'air filtré pour éviter la contamination. Ce dispositif présente l'inconvénient que la purge ne peut être effectuée que par les extrémités du tunnel, donc de façon peu efficace surtout lorsque le tunnel n'est pas rectiligne.

La présente invention pallie ces inconvénients. Elle a pour objet un couloir conçu pour pouvoir être adapté aisément à toutes les installations et pour permettre le maintien d'un environnement ultra-propre quel que soit le trajet suivi par le couloir.

De manière plus précise, l'invention a pour objet un couloir adaptable pour le transport de pièces dans un environnement ultra-propre qui est délimité par des cloisons et destiné à être placé au-dessus des moyens de transport des ces pièces, les cloisons étant formées par au moins une jupe unitaire imperméable, réalisée en matière souple et par au moins un conduit unitaire longitudinal muni de buses débouchant vers l'intérieur du couloir, le conduit unitaire et la jupe unitaire étant fixés l'un à l'autre par des systèmes d'accrochage complémentaires étanches.

L'invention peut être comprise comme un "prêt-à-monter" : des conduits unitaires et des jupes unitaires peuvent s'ajouter à volonté pour obtenir la longueur et la géométrie désirées pour le couloir.

Selon un mode de réalisation préféré, un conduit unitaire comporte sur une face orientée vers l'intérieur du couloir une rangée longitudinale d'ouvertures dans lesquelles sont fixées les buses par emboîtement étanche.

Un conduit unitaire est en matériau déformable et comporte deux faces parallèles reliées par deux bords latéraux portant des systèmes d'accrochage, chaque conduit unitaire étant terminé à ses extrémités longitudinales opposées par des parties emboîtables complémentaires.

Chaque jupe unitaire est réalisée en matière souple et comporte sur l'un au moins de ses bords latéraux un système d'accrochage complémentaire des systèmes d'accrochage portés par les bords latéraux des conduits unitaires.

Tous les éléments unitaires (conduits et jupes) sont en matériau souple et déformable. Ainsi, le couloir peut serpenter à volonté.

Le fait que les conduits unitaires s'emboîtent les uns dans les autres et que les jupes peuvent s'accrocher aux conduits dans n'importe quelle configuration permet plusieurs types de réalisation pour le couloir. Par exemple, deux conduits formés chacun d'une pluralité de conduits unitaires sont reliés par une jupe faisant office de toit. Les alignements des buses de chacun des conduits se font face. Deux autres jupes accrochées aux systèmes d'accrochage libres de chacun des deux conduits forment des cloisons souples.

Lorsque le couloir comprend au moins deux conduits juxtaposés, ces conduits sont raccordés par des pièces de liaison raccordables aux systèmes d'accrochage portés par les bords latéraux des conduits unitaires.

Dans une variante de réalisation du couloir, trois conduits sont accrochés les uns aux autres. Le conduit central, situé entre les deux conduits latéraux, fait office de toit. Les conduits latéraux pendent de chaque côté du conduit central. Les buses de chaque conduit sont orientées vers l'intérieur du conduit. Des jupes sont accrochées aux deux conduits latéraux et forment des cloisons souples.

Dans une variante de réalisation de l'invention, les buses débouchent obliquement vers l'extérieur du conduit.

Dans une autre variante de réalisation, les buses débouchent normalement à la surface du conduit.

Selon un aspect secondaire, le couloir comporte des moyens pour supporter les conduits unitaires. Ces structures peuvent prendre la forme de tréteaux, par exemple.

Les conduits sont reliés à un dispositif de pressurisation permettant de réaliser un environnement ultra-propre à l'intérieur du couloir.

Quel que soit le mode de réalisation de l'invention, les cloisons du couloir comprennent des jupes pendantes.

Les jupes d'une même cloison fixées sur un conduit se recouvrent partiellement. Par ailleurs, elles ne touchent pas le sol : un espace est laissé entre l'extrémité inférieure des jupes et le sol ; cela permet l'échappement vers l'extérieur du couloir de la surpression d'air.

L'ensemble du couloir peut donc se déformer à volonté et s'agrandir par l'emboîtement de nouveaux conduits unitaires sur lesquels pendent des jupes. Le couloir épouse les méandres du dispositif de transport et il est adaptable à tout environnement ; le choix de sa géométrie, le fait qu'il comporte un ou plusieurs conduits, la disposition des jupes : aucun de ces paramètres n'est figé grâce à la possibilité d'assemblage des éléments unitaires.

Les caractéristiques et avantages de l'invention apparaîtront mieux après la description qui suit donnée à titre explicatif et nullement limitatif. Cette description se réfère à des dessins annexés sur lesquels :
- la figure 1 représente schématiquement en perspective les éléments unitaires composant un couloir selon l'invention ;
- les figures 2A et 2B sont des vues en coupe qui représentent schématiquement deux types de buses utilisables dans le couloir de la figure 1 ;
- la figure 3 représente schématiquement en vue de dessus une partie d'un couloir pour environnement ultra-propre réalisé, à l'aide des éléments unitaires de la figure 1 ;
- la figure 4 illustre schématiquement, en section, une variante de réalisation d'un couloir selon l'invention ; et
- la figure 5 illustre schématiquement, en section, une autre variante de réalisation d'un couloir selon l'invention.

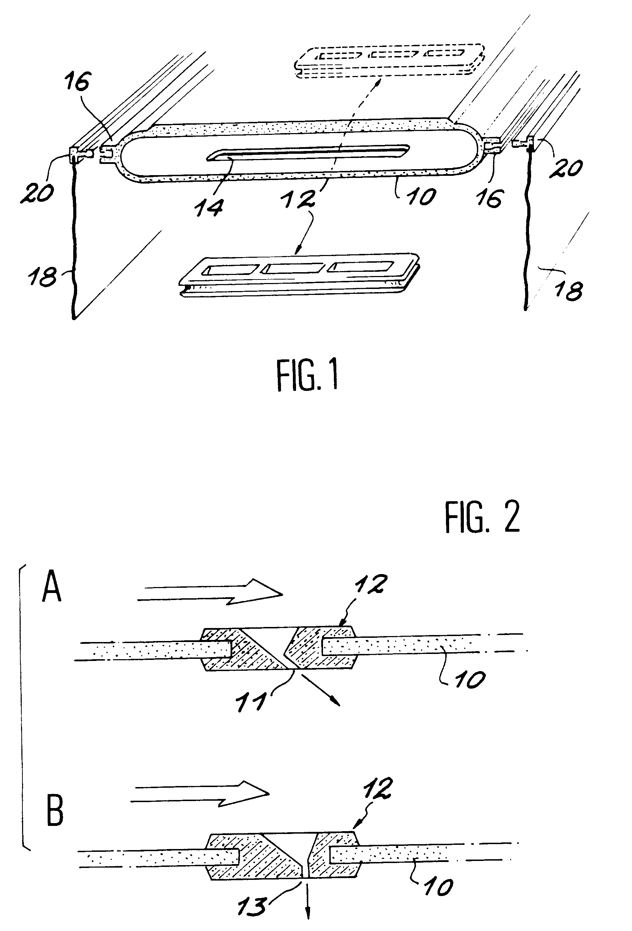

La figure 1 représente schématiquement les éléments unitaires composant un couloir selon l'invention. On voit sur cette figure un conduit unitaire 10 en matériau souple et déformable, en matière plastique par exemple. Ce conduit unitaire 10 présente deux parois planes et parallèles en vis-à-vis, reliées entre elles par deux bords latéraux, qui ont une section semi-circulaire dans l'exemple représenté :
Sur l'une des parois, prévue pour être tournée vers l'intérieur du couloir, sont pratiquées des ouvertures 14, par exemple de forme rectangulaire, orientées transversalement et régulièrement réparties selon une rangée longitudinale. Dans chaque ouverture 14, une buse 12 est montée par emboîtement.

Sur chaque bord latéral, un système d'accrochage 16 court le long du conduit unitaire 10. Ce système d'accrochage 16 est constitué par un bourrelet dans lequel est formée une rainure longitudinale s'ouvrant vers l'extérieur pour donner au bourrelet une section en forme de C.

Un second élément unitaire consiste en une jupe unitaire 18 réalisée en une matière souple et déformable, une feuille de plastique (en polyvinyle ou en polyéthylène par exemple). Cette jupe 18 est munie à l'une au moins de ses extrémités d'un système d'accrochage 20 apte à être fixé de façon étanche, de préférence par emboîtement, au système d'accrochage 16 du conduit unitaire 10. Le système d'accrochage 20 est constitué à cet effet d'un simple bourrelet longitudinal apte à être inséré dans la rainure du système d'accrochage 16.

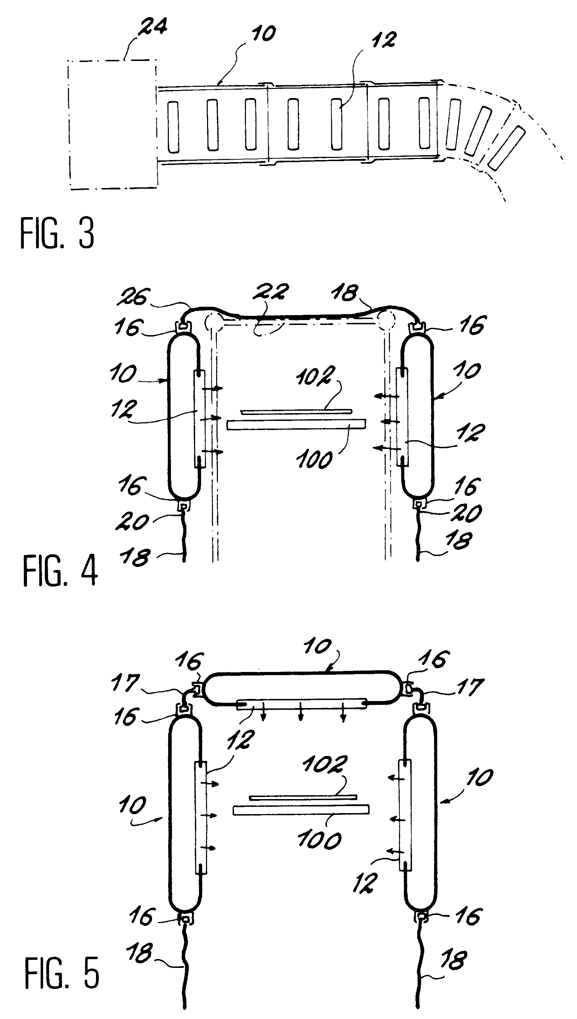

Un couloir selon l'invention, dans sa version la plus simple, consiste en un emboîtement d'une pluralité de conduits unitaires 10 formant un long conduit. Pour permettre cet emboîtement, chacun des conduits unitaires présente des extrémités longitudinales opposées de formes complémentaires, comme l'illustre la figure 3. Sur chacun de ses côtés, fixés grâce aux systèmes d'accrochage 16, 20 pendent des jupes, formées par l'association d'une pluralité de jupes unitaires 18.

La figure 2 représente schématiquement deux types de buses pouvant être utilisées sur un conduit.

On voit sur la figure 2A un exemple de buse 12 fixée dans l'une des ouvertures 14 d'un conduit unitaire 10. La fixation de la buse 12 dans l'ouverture 14 est faite par emboîtement, la partie de la paroi du conduit unitaire 10 entourant l'ouverture 14 étant reçue dans une rainure périphérique formée sur la buse 12. Cette buse est traversée par un passage 11 orienté en oblique dans une direction longitudinale. Une circulation d'air (symbolisée par des flèches en traits gras) à l'intérieur du conduit 10 est ainsi évacuée sous forme de jets (symbolisé par des flèches en traits fins) obliques à l'intérieur du couloir par le passage 11.

La figure 2B représente schématiquement une variante de buse 12 utilisée dans un couloir selon l'invention. Dans ce cas, la buse 12 est traversée par un passage 13 que débouche selon une direction normale à la surface du conduit unitaire 10. Les jets d'air évacués à l'intérieur du couloir sont donc perpendiculaires à la surface du conduit 10 (flèches en traits fins).

Les figures 1 et 3 représentent schématiquement un couloir destiné à délimiter un environnement ultra-propre. Ce couloir est constitué de conduits unitaires 10 emboîtés pour former la cloison supérieure du couloir et dont les bords latéraux supportent des jupes unitaires 18 formant les cloisons latérales du couloir. Une circulation d'air est créée à l'intérieur des conduits 10 par un dispositif de pressurisation 24.

Les jets d'air délivrés par les buses 12 à l'intérieur du couloir entretiennent un environnement ultra-propre.

La figure 4 représente schématiquement en section une variante de réalisation d'un couloir selon l'invention. Deux conduits formés à partir de conduits unitaires 10 emboîtés sont reliés par une jupe formée par la réunion de jupes unitaires 18. Cette première jupe constitue la paroi supérieure du couloir. Les deux conduits pendent de part et d'autre de cette première jupe et leurs bords latéraux inférieurs supportent des jupes latérales également formées par la réunion de jupes unitaires 18, de façon à former les parois latérales du couloir. L'ensemble est supporté par une structure de soutien 22, un tréteau métallique ou en matière plastique par exemple. A l'intérieur du couloir, on voit une piste 100 de transport sur coussin d'air et une tranche de silicium 102 se déplaçant dessus. Les buses 12 alignées sur les conduits se font face et permettent la délivrance des jets d'air à l'intérieur du couloir.

La figure 5 représente schématiquement en section une variante de réalisation d'un couloir selon l'invention.

Le couloir est composé de trois conduits formés chacun par emboîtement de conduits unitaires 10.

Les trois conduits sont reliés entre eux par des pièces de liaison longitudinales 17, à section en forme d'équerre, qui s'emboîtent dans les systèmes d'accrochage 16 des conduits unitaires. Le conduit central constitue la cloison supérieure du couloir. Les conduits latéraux pendent de part et d'autre du conduit central. Les buses 12 de tous les conduits sont tournées vers l'intérieur du couloir. Les cloisons latérales du couloir sont complétées par des jupes formées de jupes unitaires 18 qui pendent sous chacun des conduits latéraux. Une piste 100 de transport par coussin d'air peut circuler à l'intérieur du couloir. On a aussi représenté une tranche de silicium 102 se déplaçant sur la piste 100.

Les flèches représentent les jets d'air évacués par les buses et permettant de maintenir à l'intérieur du couloir un environnement ultra-propre.

Un couloir selon l'invention, grâce à ses éléments unitaires en matériaux déformables pouvant s'ajouter à volonté, peut s'adapter par ses dimensions et sa géométrie à des parcours longs et sinueux. Il est facile d'emploi : le montage et le démontage sont des opérations simples à réaliser. Allié à un dispositif de pressurisation, il permet de créer un environnement ultra-propre le long de son parcours.

## Revendications

1. Couloir adaptable pour le transport de pièces dans un environnement ultra-propre, délimité par des cloisons et destiné à être placé au-dessus des moyens de transport de ces pièces, caractérisé en ce que les cloisons sont formées par au moins une jupe unitaire (18) imperméable, réalisée en matière souple et par au moins un conduit unitaire (10) longitudinal muni de buses (12) débouchant vers l'intérieur du couloir, le conduit unitaire (10) et la jupe unitaire (18) étant fixés l'un à l'autre par des systèmes d'accrochage (16, 20) complémentaires étanches.

2. Couloir selon la revendication 1, caractérisé en ce que chaque conduit unitaire (10) comporte sur une face orientée vers l'intérieur du couloir, une rangée longitudinale d'ouvertures (14) dans lesquelles les buses (12) sont fixées par emboîtement étanche.

3. Couloir selon la revendication 1, caractérisé en ce qu'un conduit unitaire (10) est en matériau déformable et comporte deux faces parallèles reliées par deux bords latéraux portant les systèmes d'accrochage (16), chaque conduit unitaire (10) étant terminé à ses extrémités longitudinales opposées par des parties emboîtables complémentaires.

4. Couloir selon la revendication 1, caractérisé en ce que chaque jupe unitaire (18) comporte sur l'un au moins de ses bords latéraux un système d'accrochage (20) complémentaire des systèmes d'accrochage (16) portés par les bords latéraux des conduits unitaires (10).

5. Couloir selon la revendication 3, caractérisé en ce que lorsque le couloir comprend au moins deux conduits unitaires (10) juxtaposés, ces conduits sont raccordés par des pièces de liaison (17), raccordables aux systèmes d'accrochage (16) portés par les bords latéraux des conduits unitaires (10).

6. Couloir selon la revendication 1, caractérisé en ce que les buses 12 débouchent obliquement à l'extérieur du conduit.

7. Couloir selon la revendication 1, caractérisé en ce que les buses (12) débouchent normalement à la surface du conduit.

8. Couloir selon la revendication 1, caractérisé en ce qu'il comporte des moyens (22) pour supporter les conduits unitaires (10).

9. Couloir selon la revendication 1, caractérisé en ce qu'au moins un conduit du couloir est relié à un dispositif de pressurisation.

## Patentansprüche

1. Durchgang, der für den Transport von Teilen in einer ultrasauberen Umgebung geeignet ist und der von Trennwänden begrenzt ist und dazu bestimmt ist, oberhalb von Transportvorrichtungen für diese Teile angeordnet zu werden, dadurch gekennzeichnet, daß die Trennwände wenigstens aus einer einheitlichen, undurchdringlichen Schürze (18), die aus einem elastischen Material besteht, und aus wenigstens einer einheitlichen, longitudinalen Röhre (10), die mit Düsen (12) versehen ist, die in das Innere des Durchgangs münden, geformt sind, wobei die einheitliche Röhre (10) und die einheitliche Schürze (18) aneinander mit gegeneinander dichten Verankerungssystemen (16, 20) befestigt sind.

2. Durchgang nach Anspruch 1, dadurch gekennzeichnet, daß jede einheitliche Röhre (10) auf einer ins Innere des Durchgangs gerichteten Fläche eine longitudinale Reihe von Öffnungen (14) aufweist, in denen die Düsen (12) durch dichte Einpassung befestigt sind.

3. Durchgang nach Anspruch 1, dadurch gekennzeichnet, daß eine einheitliche Röhre (10) aus verformbaren Material besteht und zwei parallelen Flächen aufweist, die miteinander über zwei laterale Ränder, die die Verankerungssysteme (16) tragen, verbunden sind, wobei jede einheitliche Röhre (10) an ihren gegenüberliegenden, longitudinalen Enden von komplett einpaßbaren Teilen abgeschlossen ist.

4. Durchgang nach Anspruch 1, dadurch gekennzeichnet, daß jede einheitliche Schürze (18) auf wenigstens einer ihrer seitlichen Ränder ein Verankerungssystem (20) aufweist, das zu den von den lateralen Rändern der einheitlichen Röhren (10) getragenen Verankerungssystemen (16) komplementär ist.

5. Durchgang nach Anspruch 3, dadurch gekennzeichnet, daß, wenn der Durchgang wenigstens zwei einheitliche, nebeneinander angeordnete Röhren (10) aufweist, diese Röhren über Verbindungsteile (17) verbunden sind, die mit den von den seitlichen Rändern der einheitlichen Röhren (10) getragenen Verankerungssystemen (16) verbindbar sind.

6. Durchgang nach Anspruch 1, dadurch gekennzeichnet, daß die Düsen (12) schräg ins Äußere der Röhre münden.

7. Durchgang nach Anspruch 1, dadurch gekennzeichnet, daß die Düsen (12) senkrecht zur Oberfläche der Röhre münden.

8. Durchgang nach Anspruch 1, dadurch gekennzeichnet, daß er Vorrichtungen (22) zum Halten der einheitlichen Röhren (10) aufweist.

9. Durchgang nach Anspruch 1, dadurch gekennzeichnet, daß wenigstens eine Röhre des Durchgangs mit einer Druckvorrichtung verbunden ist.

## Claims

1. Adaptable passage for transporting parts in an ultra-clean environment, defined by partitions and intended to be placed above means for transporting said parts, characterized in that the partitions are formed by at least one impermeable, unitary skirt (18) made from a flexible material and by at least one longitudinal, unitary pipe (10) provided with nozzles (12) issuing towards the inside of the passage, the unitary pipe (10) and the unitary skirt (18) being fixed to one another by complementary, tight fastening systems (16, 20).

2. Passage according to claim 1, characterized in that each unitary pipe (10) has on a face oriented towards the inside of the passage, a longitudinal row of openings (14) into which are tightly fitted the nozzles (12).

3. Passage according to claim 1, characterized in that a unitary pipe (10) is made from a deformable arterial and has two parallel faces connected by two lateral edges carrying fastening system (16), each unitary pipe (10) being terminated at its opposite longitudinal ends by complementary nestable parts.

4. Passage according to claim 1, characterized in that each unitary skirt (18) is made from a flexible material and has on at least one of its lateral edges a fastening system (20) complementary with regards to the fastening system (16) carried by the lateral edges of the unitary pipes (10),

5. Passage according to claim 3, characterized in that when the passage comprises at least two juxtaposed pipes, the latter are connected by linking parts (17) connectable to the fastening system (16) carried by the lateral edges of the unitary pipes (10).

6. Passage according to claim 1, characterized in that the nozzles (12) issue obliquely to the outside of the pipe.

7. Passage according to claim 1, characterized in that the nozzles (12) issue perpendicular to the surface of the pipe.

8. Passage according to claim 1, characterized in that it has means (22) for supporting the unitary pipes (10).

9. Passage according to claim 1, characterized in that at least one pipe of the passage is connected to a pressurizing device.
